# EUROPÄISCHE PATENTSCHRIFT

(11) **EP 3 175 542 B1**
(45) Veröffentlichungstag und Bekanntmachung des Hinweises auf die Patenterteilung: **01.09.2021**
(21) Anmeldenummer: 15735715.3
(22) Anmeldetag: 14.07.2015
(51) Int. Cl.: H02M 3/337, H02M 1/00, H02M 3/335

(54) **POTENTIALGETRENNTE AKTIVE SCHALTUNG ZUR ERFASSUNG EINES SEKUNDÄRSEITIGEN LEUCHTMITTEL-STROMS**
GALVANICALLY SEPARATED ACTIVE DETECTION CIRCUIT FOR SECONDARY SIDE ILLUMINANT CURRENT
CAPTEUR ACTIF AVEC SÉPARATION ÉLECTRIQUE POUR COURANT SECONDAIRE DANS UN AGENT LUMINEUX

(30) Priorität: 28.07.2014 DE 102014214744
(43) Veröffentlichungstag der Anmeldung: 07.06.2017
(73) Patentinhaber: Tridonic GmbH & Co. KG, 6851 Dornbirn (AT)
(72) Erfinder: MARTE, Patrick, A-6840 Götzis (AT); BACHMANN, Johannes, A-6840 Götzis (AT)
(74) Vertreter: Rupp, Christian
(86) Internationale Anmeldenummer: PCT/EP2015/066049
(87) Internationale Veröffentlichungsnummer: WO 2016/015995

(56) Entgegenhaltungen:
- EP-A1- 2 493 063
- EP-A1- 2 770 623
- EP-A1- 3 078 242
- EP-A2- 2 741 409
- EP-A2- 2 741 409
- CN-A- 102 636 676
- US-A- 5 574 338
- US-A1- 2011 037 414
- LIU Y-F ET AL: "A NEW CURRENT SENSING SCHEME FOR ZERO-VOLTAGE SWITCHING PHASE-SHIFTED BRIDGE CONVERTER", INTELEC 2000. 22ND. INTERNATIONAL TELECOMMUNICATIONS ENERGY CONFERENCE. PHOENIX, AZ, SEPT. 10 - 14, 2000; [INTELEC. INTERNATIONAL TELECOMMUNICATIONS ENERGY CONFERENCE], NEW YORK, NY : IEEE, US, Bd. CONF. 22, 10. September 2000 (2000-09-10), Seiten 567-573, XP000968740, ISBN: 978-0-7803-6408-0
- ANONYMOUS: "AN-9729. LED Application Design Guide Using Half-Bridge LLC Resonant Converter for 100W Street Lighting", INTERNET CITATION, 16. November 2012 (2012-11-16), Seiten 1-14, XP002707759, Gefunden im Internet: URL:http://www.fairchildsemi.com/an/AN/AN- 9729.pdf [gefunden am 2013-07-30]
- A. Nonymous: "UBA20270 600V Driver IC for dimmable compact fluorescent lamps", , 8 September 2011 (2011-09-08), pages 1-32, XP055478454, Retrieved from the Internet: URL:https://www.nxp.com/docs/en/data-sheet /UBA20270.pdf [retrieved on 2018-05-25]

## Beschreibung

Die Erfindung bezieht sich auf eine aktive Schaltung, insbesondere eine Treiberschaltung, zur Erfassung eines Stroms durch eine Leuchtmittelstrecke mit wenigstens einer LED. Insbesondere bezieht sich die Erfindung auf eine aktive Schaltung, die durch eine potenzialtrennende und/oder galvanisch isolierende Barriere (beispielsweise eine Sicherheitskleinspannungsbarriere (SELV-Barriere)) in eine von einer Versorgungsspannung aus versorgte Primärseite und eine die Leuchtmittelstrecke versorgende Sekundärseite aufgeteilt ist.

Bekannt ist es, dass bei solchen Schaltungen von der Primärseite der Schaltung zu der Sekundärseite der Schaltung eine Energieübertragung stattfindet. Insbesondere erfolgt die Übertragung von der Primärseite zu der Sekundärseite der Schaltung über die Barriere hinweg mittels eines Wandlers, insbesondere eines Transformators, der mittels einer elektromagnetischen Kopplung eine Spannung bzw. einen Strom auf der Sekundärseite induziert. Somit ist es möglich, über die Barriere hinweg die Sekundärseite zu versorgen.

Zur Ermittlung des Leuchtmittelstroms durch das Leuchtmittel, bzw. die Leuchtmittelstrecke, der zur Regelung der Leuchtmittelhelligkeit verwendet werden kann, ist es bekannt, eine Ermittlung des Leuchtmittelstroms auf der Sekundärseite durchzuführen. Dies ist z.B. in der WO 2014/060899 gezeigt. Bekannt ist zudem, dass, wie exemplarisch auch in der Fig. 1 gezeigt, eine Steuerschaltung SE eine Schaltereinheit S mit einem getakteten Schalter direkt oder indirekt ansteuert, z.B. über eine Treibereinheit.

Die Schaltereinheit S kann beispielsweise einen einzelnen getakteten Schalter oder mehrere getaktete Schalter aufweisen. So kann die Schaltereinheit S insbesondere einen Wechselrichter mit einem Hochpotential ("high-side")-Schalter und einem im Vergleich dazu Niederpotential ("low-side")-Schalter umfassen.

Ausgehend von der Schaltereinheit S wird dann eine Wandlerwicklung L2_1 (Induktivität, Spule) versorgt. Diese Wandlerwicklung L2_1 kann dabei Teil einer LLC-Schaltung sein und beispielsweise von einem Mittenpunkt des Wechselrichters gespeist werden. Insbesondere wird also ein Wandler (z.B. Resonanzwandler, LLC-Wandler) gespeist, von dem ausgehend die Sekundärseite der Schaltung durch elektromagnetische Kopplung der primärseitigen Wandlerwicklung L2_1 und der sekundärseitigen Wandlerwicklung L2_2, L2_3 (hier als separate Wicklungen L2_2, L2_3 dargestellt; diese sind magnetisch gekoppelt) über eine Barriere B hinweg gespeist wird.

Über die Dioden D1 und D2, die einen Gleichrichter bilden, wird LED-Anschlüssen LED+ und LED- eine über einen Glättungskondensator C2 geglättete Gleichspannung zum Betrieb des Leuchtmittels zugeführt.

Eine Hilfswicklung Lh ist mit einer Erfassungsschaltung E auf der Sekundärseite der Schaltung vorgesehen, wobei die Hilfswicklung Lh elektromagnetisch mit der primärseitigen Wicklung L2_1 gekoppelt ist. Die Erfassungsschaltung E erfasst dann mittels der Hilfswicklung Lh einen auf der Sekundärseite der Schaltung induzierten Strom, bzw. einen diesen wiedergebenden Parameter. Der entsprechende den Strom wiedergebende Parameter wird dabei durch die Erfassungsschaltung E ermittelt und über ein Überbrückungselement X, das beispielsweise ein Optokoppler oder ein weiterer Transformator sein kann, über die Barriere B zu der Steuereinheit SE zurück geführt. Die Steuereinheit SE kann den Parameter dann als Ist-Wert für den Strom durch das Leuchtmittel auswerten, und zur Regelung des Leuchtmittels verwenden. Dabei kann die Steuereinheit SE insbesondere den Ist-Wert für den Strom mit einem Sollwert vergleichen und entsprechend die Schaltereinheit S ansteuern.

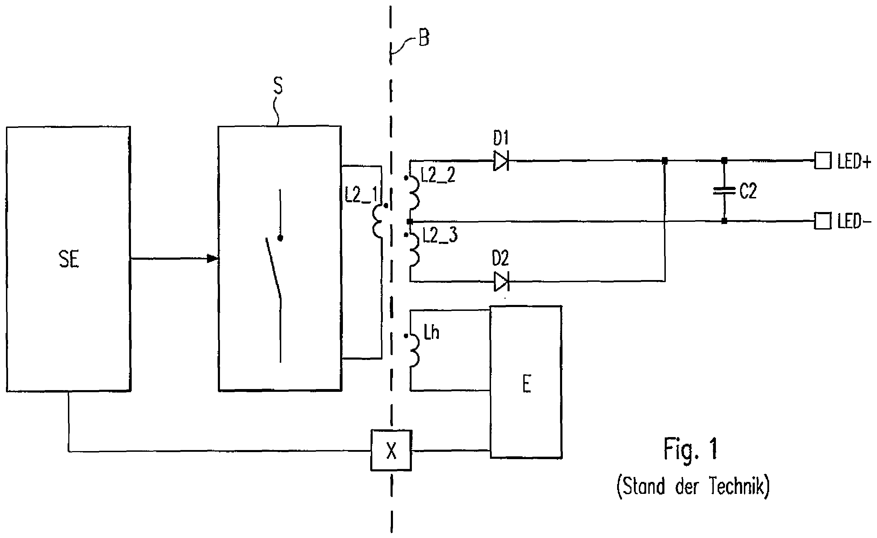

Die in Fig. 1 dargestellte Schaltung hat indessen den Nachteil, dass einerseits die Erfassungsschaltung E auf der Sekundärseite der Schaltung vorgesehen sein muss, und weiter ein Überbrückungselement X benötigt wird, um die Barriere B zu überbrücken, was zu relativ hohen Schaltungskosten und komplizierten Schaltungsanordnungen führt.

Das Dokument CN 102636676 A offenbart eine transformatorisch gekoppelte Stromauswerteschaltung mit einem aktiven Gleichrichter. Die diagonalen Schalter des Erfassungsgleichrichters werden synchron mit den diagonalen Schalter einer primärseitigen Vollbrücke geschaltet. Das Stromsignal wird einer Steuereinheit zugeführt und zur Ansteuerung der primärseitigen Schalter verwendet.

Die Veröffentlichung LIU Y-F ET AL: "A NEW CURRENT SENSING SCHEME FOR ZERO-VOLTAGE SWITCHING PHASE-SHIFTED BRIDGE CONVERTER", INTELEC 2000. 22ND. INTERNATIONAL TELECOMMUNICATIONS ENERGY CONFERENCE. PHOENIX, AZ, SEPT. 10 - 14, 2000; [INTELEC. INTERNATIONAL TELECOMMUNICATIONS ENERGY CONFERENCE], NEW YORK, NY : IEEE, US, Bd. CONF. 22, 10. September 2000 (2000-09-10), Seiten 567-573 offenbart verschiedene Alternativen für die Anordnung transformatorischer Strommessungen in einem isolierten DC/DC Wandler.

EP 2 493 063 A1 offenbart eine sekundärseitig gekoppelte transformatorische Strommessung in einem isolierten DC/DC Wandler, welche mit einem passiven Auswertungsgleichrichter gekoppelt ist.

Es ist daher ein Ziel der Erfindung, eine Schaltung bereitzustellen, die eine primärseitige Erfassung eines den Strom durch das Leuchtmittel wiedergebenden Parameters ermöglicht. Insbesondere ist es die Aufgabe der Erfindung, eine Möglichkeit bereitzustellen, auf der Primärseite der Schaltung einen den Strom durch das Leuchtmittel wiedergebenden Parameter zu erfassen und dabei Erfassungsfehler zu vermeiden.

Eine Lösung für diese Aufgabe wird im Folgenden beschrieben und durch die Vorrichtung nach Anspruch 1 gelöst.

Die Erfindung wird auch mit Bezug auf die Figuren beschrieben. Dabei zeigen:
- Fig. 1: schematisch eine bekannte Ausführungsform nach dem Stand der Technik.
- Fig. 2: schematisch ein erstes Beispiel, was nicht in den Schutzumfang fällt.
- Fig. 3: exemplarisch eine detailliertere Schaltungsanordnung gemäß eines Beispiels, was nicht in den Schutzumfang fällt.
- Fig. 4: exemplarische Kurven erfasster Parameter.
- Fig. 5: schematisch eine Blockdarstellung einer aus der in Figur 3 gezeigten Schaltung entwickelten Ausführungsform.
- Fig. 6: exemplarisch eine detailliertere Schaltungsanordnung gemäß einer Ausführungsform der Erfindung.
- Fig. 7: Zustände von Schaltungsteilen bei bestimmter Ansteuerung.

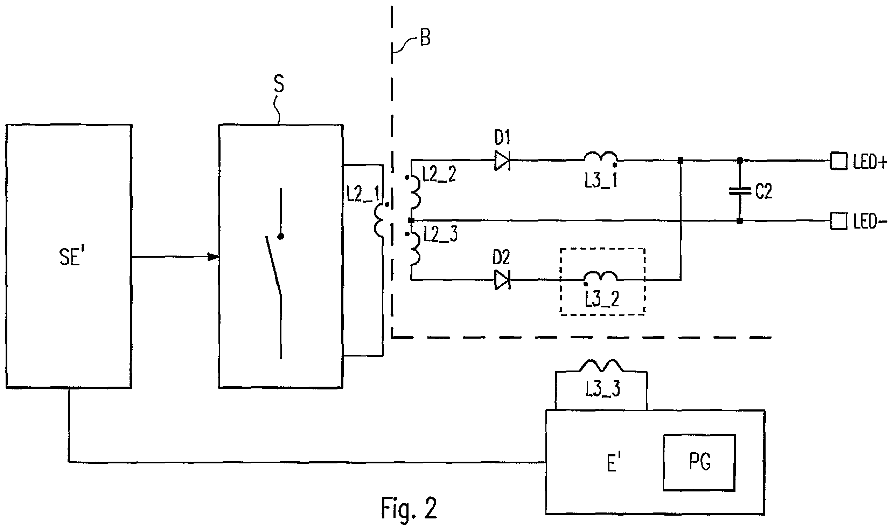

Fig. 2 zeigt nun ein erstes Beispiel einer ähnlichen Schaltung, die nicht in den Schutzumfang des Anspruchs fällt, bei der gleiche Bezugszeichen im Wesentlichen gleiche Schaltungsteile bezeichnen wie in Fig. 1. Wie aus Fig. 2 ersichtlich, ist in Serie mit wenigstens einer sekundärseitigen Wandlerwicklung L2_2, L2_3 (es können auch, wie dargestellt zwei Wandlerwicklungen vorgesehen sein, die vorzugsweise miteinander magnetisch gekoppelt sind) eine Diode verbunden die wiederum mit einer Primärwicklung L3_1 eines Transformators in Serie Verbunden ist. Die Primärwicklung L3_1 des Transformators und ist dabei in dem Versorgungspfad des Leuchtmittelanschlusses LED+ angeordnet.

Die Primärwicklung L3_1 des Transformators ist mit einer Sekundärwicklung L3_3 des Transformators elektromagnetisch gekoppelt.

In Fig. 2 ist in einem gestrichelten Rahmen exemplarisch eine, mit einer Diode D2 in Serie geschaltete, primärseitige weitere Primärwicklung L3 2 des Transformators gezeigt, die optional vorgesehen sein kann.

Die Sekundärwicklung L3_3 des Transformators ist dabei mit einer Erfassungsschaltung E' verbunden, die einen passiven Erfassungsgleichrichter PG aufweist. Dieser richtet die, insbesondere Wechselweise durch die Primärwicklungen L3_1, L3_2 des Transformators übertragene Spannung zu einer Gleichspannung gleich.

An einem Ausgang des passiven Erfassungsgleichrichter PG kann somit eine Erfassung des den Strom durch das Leuchtmittel wiedergebenden Parameters, z.B. über einen Strommesswiderstand, erfolgen. Der Parameter ist wiederrum einer Steuereinheit SE' zurückgeführt, die ihn vorzugsweise als Ist-Wert für den Strom durch das Leuchtmittel (nicht gezeigt) auswertet und eine entsprechende Regelung durchführt. Zum Anschluss des Leuchtmittels, das vorzugsweise wenigstens eine LED aufweist, sind, wie in Fig. 1, die Anschlüsse (Terminals) LED- und LED+ vorgesehen.

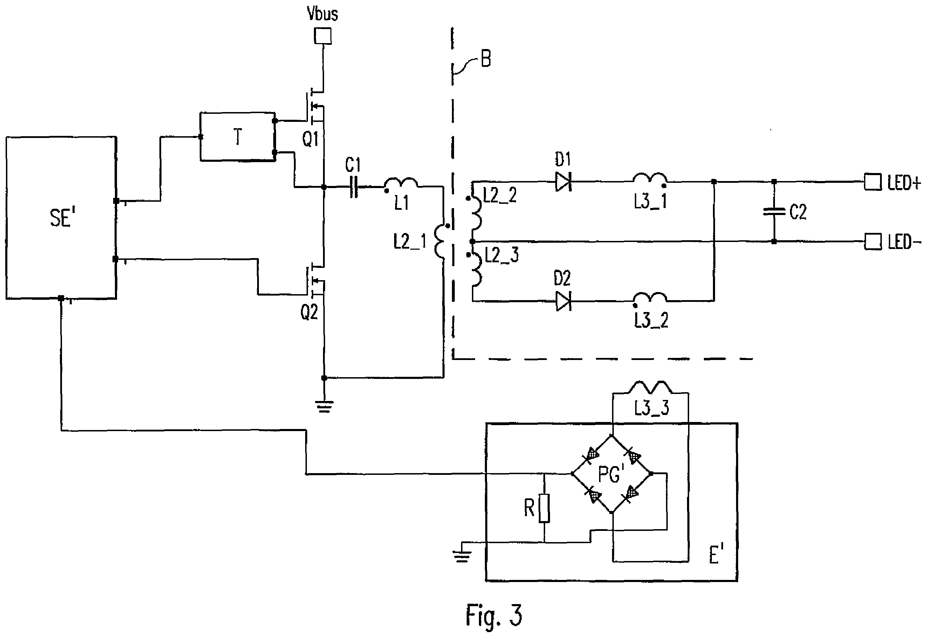

Eine exemplarische Ausgestaltung des nicht in den Schutzumfang fallenden Beispiels von Fig. 2 ist in Fig. 3 gezeigt. Auch hier bezeichnen gleiche Bezugszeichen gleiche Schaltungsteile wie in Figs. 1 und 2.

Insbesondere ist in Fig. 3 eine Steuereinheit SE' vorgesehen, die einen Wechselrichter mit einem ersten Wechselrichterschalter Q1 und einem zweiten Wechselrichterschalter Q2 ansteuert. Der erste Wechselrichterschalter Q1 ist hier ein "high-side-switch", also der Schalter "über" der Last bzw. der potentialhöhere Schalter, und wird über einen Treiber T angesteuert, während der zweite Wechselrichterschalter Q2 einen "low-side-switch" (Schalter "unter" der Last bzw. potentialniedrigere Schalter) darstellt.

Ausgehend von einem Mittenpunkt zwischen dem ersten und zweiten Wechselrichterschalter Q1, Q2 der dargestellten Wechselrichterhalbbrücke wird ein Resonanzwandler (hier LLC-Wandler) mit einer Kapazität C1, einer Induktivität L1 und einer primären Wandlerwicklung L2_1 gespeist.

Die Sekundärseite der Schaltung ist im Wesentlichen identisch zu der aus Fig. 2. Auch hier kann eine der Primärwicklungen L3_1, L3_2 des Transformators optional vorgesehen sein.

Weiter ist der passive Erfassungsgleichrichter PG' als Teil der Erfassungsschaltung E' auf der Primärseite der Schaltung als Dioden-Vollbrücke ausgebildet und die Steuereinheit SE' erfasst an seinem Ausgang einen den Strom durch das Leuchtmittel wiedergebenden Parameter über einen Messwiderstand R.

Mit den Anordnungen aus den Fig. 2 und Fig. 3 kann nun auf der Primärseite der Schaltung der den Strom durch das Leuchtmittel wiedergebende Parameter erfasst werden. Da insbesondere beide dem Leuchtmittel zugeführten Halbwellen transformatorisch übertragen werden, können auch entsprechende Stromwerte für beide Halbwellen erfasst werden.

Problematisch ist hierbei jedoch, dass die typischerweise auf der Sekundärseite der Schaltung als Gleichrichter eingesetzten Dioden D1, D2 bei hohen Temperaturen einen "Reverse-Strom" aufweisen, d.h. dass durch die Dioden D1, D2 kein unmittelbares Abschalten erfolgt, sondern ein Strom durch die Dioden D1, D2 des Gleichrichters in Sperrrichtung der Dioden D1, D2 fließt.

Aufgrund der transformatorischen Auskopplung und der Gleichrichtung durch den passiven Erfassungsgleichrichter PG' ergibt sich ein Fehlerpotenzial, das besonders bei hohen Temperaturen das von der Steuereinheit SE' erfasste Signal stark stört.

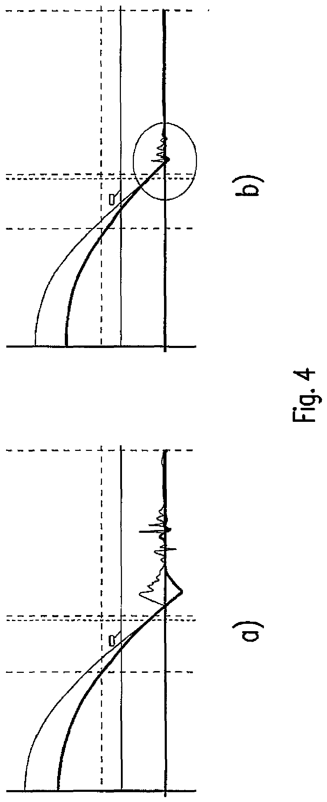

Dies wird aus den exemplarisch in den Figs. 4a und 4b gezeigten Kurven deutlich, wobei die Fig. 4a einen Kurvenverlauf bei hohen Temperaturen illustriert. In der Darstellung stellt die schwarze, von links nach rechts zunächst abfallende Kurve, einen Stromverlauf durch die Diode D1 dar, während die graue, von links nach rechts abfallende Kurve, das an dem Messwiderstand R erfasste Signal darstellt.

Der passive Erfassungsgleichrichter PG' ist jedoch nicht in der Lage den negativen "Reverse-Strom" der Diode korrekt auszugeben, was zu einer Verschiebung des gemessenen Signals führt, dass an den Messwiderstand R erfasst wird.

In Fig. 4b sind entsprechende Kurven für niedrigere Temperaturen gezeigt. Aus Fig. 4b wird deutlich, dass je kleiner die Temperatur ist, desto geringer ist auch der Einfluss des in Sperrrichtung fließenden "Reverse-Stroms" an der Diode D1. Somit ist der Erfassungsfehler bei niedrigen Temperaturen reduziert. Der erfasste und fälschlicherweise positiv gemessene "Reverse-Strom" ist bei den niedrigen Temperaturne viel geringer. Der entsprechende Bereich ist in Fig. 4b gekennzeichnet.

Es ist zu verstehen, dass sich ein entsprechender Signalverlauf auch für die Diode D2 ergeben kann, sodass sich eine entsprechende Fehleraddition für jede durch die wenigstens ein primäre Transformatorenwicklung L3_1, L3_2 in der sekundären Transformatorenwicklung L3_3 induzierte Halbwelle ergibt.

Insgesamt bezieht sich die Erfindung also auf die Erfassung des LED-Stroms wobei dieser Strom ausgehend von einer AC-Spannung ermittelt wird die mittels der Dioden D1, D2 gleichgerichtet wird. Eine Erfassung des LED-Stroms erfolgt also indirekt über den Transformator, der zwei Primärwicklungen L3_1 und L3_2 aufweist, die mit jeweils einer der Dioden D1, D2 in Serie geschaltet sind.

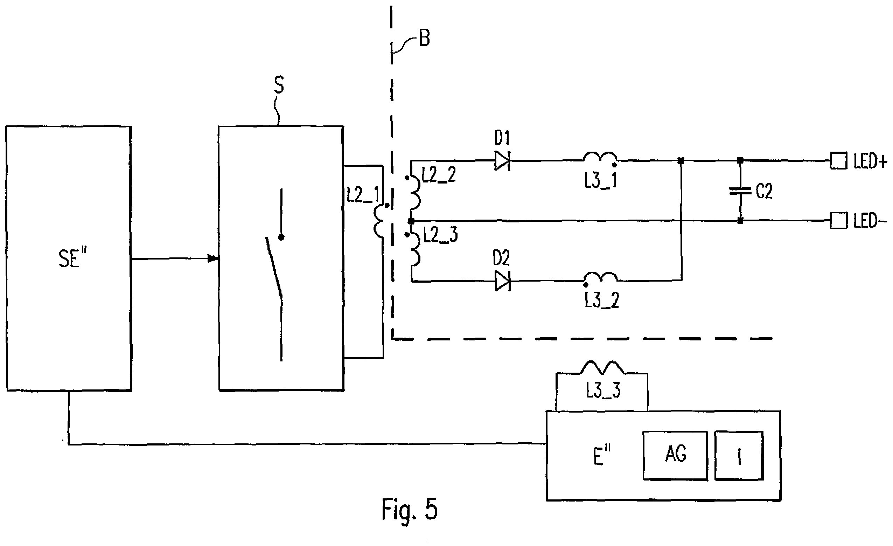

Die in Fig. 5 dargestellte Schaltung erlaubt nun eine Erfassung eines LED-Stroms auf der Primärseite der Schaltung bei gleichzeitiger Vermeidung der durch den "Reverse-Strom" hervorgerufenen Erfassungsfehler.

Im Vergleich zur Fig. 3 ist der passive Erfassungsgleichrichter PG, PG' durch einen aktiven Erfassungsgleichrichter AG in einer Erfassungsschaltung E" ersetzt, bei dem die Sekundärwicklung des Transformators L3_3 mit vier Gleichrichterschaltern verschaltet ist.

Dabei werden die Gleichrichterschalter derart angesteuert, dass jeweils eine Diagonale des Gleichrichters aktiv, das heißt leitend geschaltet ist, sodass letztlich wechselnd eine Anzapfung der Sekundärwicklung erfolgt. Dabei steuert die Steuereinheit SE" die Gleichrichterschalter an, die auch die Schaltereinheit S ansteuert.

Auch in Fig. 5 bezeichnen gleiche Bezugszeichen im Wesentlichen gleiche Elemente wie in den vorhergehenden Figs.

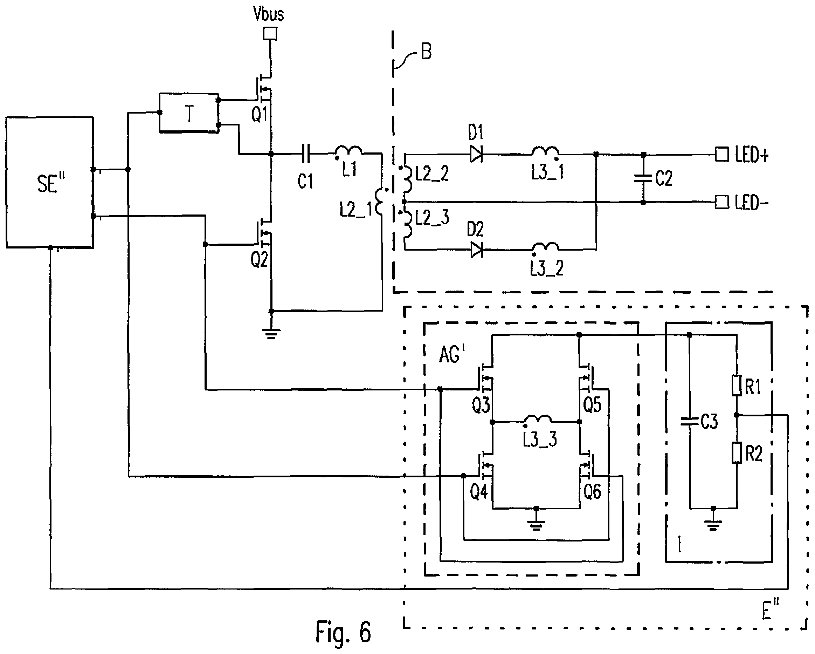

In Fig. 6 ist die detaillierte Ausgestaltung der Ausführungsform aus Fig. 5 gezeigt. Diese geht aus von der in Fig. 3 gezeigten beispielhaften Schaltungsanordnung, die nicht in den Schutzumfang des Anspruchs fällt. In Fig. 3 im Wesentlichen bereits gezeigte Schaltungskomponenten sind entsprechend analog bezeichnet.

In Fig. 6 ist insbesondere der aktive Erfassungsgleichrichter AG' gezeigt, wobei die Sekundärwicklung L3_3 des Transformators mit einem ersten Gleichrichterschalter Q3 und einem zweiten Gleichrichterschalter Q6 verbunden ist und eine erste Diagonale bildet, während die Sekundärwicklung L3_3 des Transformators auch mit einem dritten Gleichrichterschalter Q4 und einen vierten Gleichrichterschalter Q5 verbunden ist und damit eine zweite Diagonale bildet.

Wie in Fig. 6 gezeigt wird der erste Gleichrichterschalter Q3 und der zweite Gleichrichterschalter Q6 der ersten Diagonale synchron mit dem low-side Wechselrichterschalter Q2 geschaltet, während der dritte Gleichrichterschalter Q4 und der vierte Gleichrichterschalter Q5 synchron mit dem high-side Wechselrichterschalter Q1 angesteuert wird.

Im Vergleich zu den passiven Gleichrichtern PG, PG' aus den Figs. 2 und 3 wird also durch Umschalten der Anzapfung der Sekundärwicklung L3_3 der Fehlerinduzierende "Reverse-Strom" als negativer Strom gemessen, sodass durch die Steuereinheit SE" der Leuchtmittel-Strom durch eine entsprechende Ansteuerung der Schaltereinheit S auf der Primärseite der Schaltung erfolgen kann. Der "Reverse-Strom" kann dann durch eine solche entsprechende Ansteuerung kompensiert werden.

Die Erfassung des den Strom durch das Leuchtmittel wiedergebenden Parameters wird dann mittels einer Integrationsschaltung I, insbesondere eines RC-Integrationsschaltkreises, erfolgen. Beispielsweise kann an einem Spannungsteiler, der gebildet wird aus den Widerständen R1, R2, an deren Mittenpunkt ein Rückführsignal durch die Steuereinheit SE" erfasst werden. Der Spannungsteiler R1, R2 ist dabei mit einem Kondensator C3 parallel geschaltet. Der Parallelschaltung wird an dem potenzialhöheren Anschluss des Kondensators C3 das gleichgerichtete Ausgangssignal von dem aktiven Erfassungsgleichrichter AG' zugeführt.

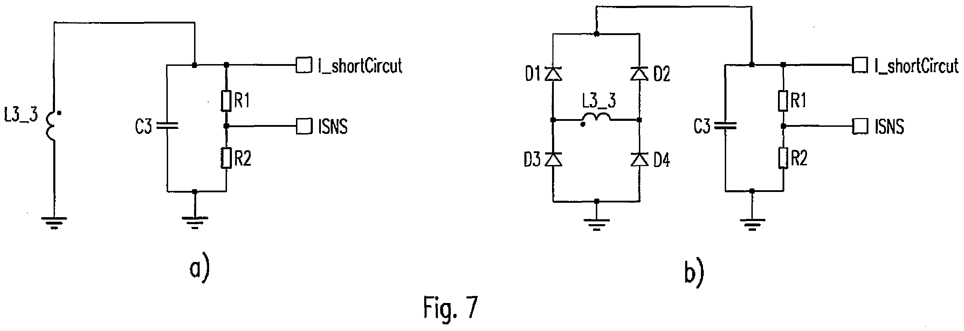

Die Figuren 7a und 7b zeigen nun Messschaltbilder für verschiedene Zustände des aktiven Gleichrichters:
Wird der aktive Erfassungsgleichrichter AG, AG' von der Steuerschaltung SE" so betrieben, dass jeweils exklusiv eine Diagonale aktiv ist, so werden positive und negative Ströme direkt dem RC-Integrationsschaltkreis I bestehend aus dem Kondensator C3 sowie dem dazu parallel geschalteten Spannungsteiler mit den Widerständen R1 und R2 zugeführt. Dabei wird die Polarität der Sekundärwicklung L3_3 unterschieden, die synchron zu der Ansteuerung der Wechselrichterschalter Q1 und Q2 ist.

Wird der Erfassungsgleichrichter AG, AG' nahe der Resonanzfrequenz des Wandlers (hier LLC) betrieben, fließt auch in der Totzeit des Wechselrichters, das heißt zu der Zeit zu der keiner der Wechselrichterschalter Q1 und Q2 aktiv ist, dennoch ein Strom. Der Strom fließt dann über die Body-Dioden der Gleichrichterschalter Q3 - Q6 und somit ebenfalls in die RC-Integrationsschaltung I. Dies erfolgt jedoch nur bei sehr großen Lasten und der dadurch hervorgerufene Fehler ist marginal im Vergleich zu dem Fehler der bei der Verwendung eines passiven Gleichrichters PG, PG' auftritt.

Die Erfindung bezieht sich also ganz allgemein auf die Erfassung eines Messsignals an Primärwicklungen L3_1, L3_2 eines Transformators, die in Serie zu Dioden D1, D2 geschaltet sind, wobei die Sekundärwicklung L3_3 des Transformators als Diagonale einer aktiven Brückenschaltung (insbesondere Vollbrückenschaltung) geschaltet ist. Dabei erfolgt die Ansteuerung der Gleichrichterschalter Q3 - Q6 durch unmittelbare Verwendung der Steuersignale der beiden getakteten Schalter (Q1, Q2) des die Sekundärseite versorgenden Wandlers. Somit ist auch kein weiterer Erfassungseingang an der Steuereinheit SE', SE" erforderlich und eine Ansteuerung der Gleichrichterschalter Q3 - Q6 kann ohne separate Treiberschaltung erfolgen. Die Primärwicklungen L3_1, L3_2 sind also direkt in den Leistungsversorgungspfaden der Leuchtmittelstrecke geschaltet.

Es ist zu verstehen, dass die beschriebenen Schalter als Transistoren (z.B. FET, MOSFET, ...) ausgebildet sein können. Die Steuereinheit SE, SE" kann z.B. als Microcontroller, IC oder ASIC ausgebildet sein.

## Patentansprüche

1. Treiberschaltung zum Betreiben eines Leuchtmittels, vorzugsweise wenigstens einer LED, aufweisend:
• einen potentialgetrennten, primärseitig von einer Steuereinheit (SE") der Treiberschaltung mittels einer angesteuerten Halbbrücken-Schaltereinheit (S) mit folgendem Serienresonanzkreis (C1, L1) getakteten LLC-Wandler der einen Gleichrichter (D1, D2) der Treiberschaltung auf einer Sekundärseite des Wandlers speist, von dem ausgehend das Leuchtmittel versorgbar ist,
• wobei der Wandler einen ersten Transformator mit zwei Wicklungen (L2-2, L2-3) mit Mittenabgriff auf der Sekundärseite aufweist,
• wobei der Gleichrichter zwei Dioden (D1, D2) aufweist, die jeweils mit einer der beiden Wicklungen des ersten Transformators in Serie verbunden sind,
• eine Erfassungsschaltung (E") der Treiberschaltung zur indirekten Erfassung des Stroms auf der Sekundärseite des Wandlers,
• wobei auf der Sekundärseite des ersten Transformators des Wandlers jeweils eine Primärwicklung (L3_1, L3_2) eines zweiten Transformators (L3_1, L3_3) der Treiberschaltung in Serie zu jeweils einer der beiden Dioden (D1, D2) angeordnet ist,
• wobei die Erfassungsschaltung (E") einen auf der Primärseite des Wandlers angeordneten Erfassungsgleichrichter (AG') aufweist, und eine Sekundärwicklung (L3_3) des zweiten Transformators (L3_1, L3_3) Teil einer ersten und zweiten Diagonalen des Erfassungsgleichrichters (AG') ist,
• wobei die erste und die zweite Diagonale jeweils zwei Gleichrichterschalter (Q3, Q4, Q5, Q6) aufweisen,
• wobei zu der Steuereinheit (SE") von einem Ausgang der Erfassungsschaltung (E") ein den Strom durch das Leuchtmittel wiedergebender Parameter zurückgeführt ist, und der Ausgang direkt oder indirekt mit einem Messeingang der Steuereinheit (SE") verbunden ist,
• wobei die Steuereinheit (SE"), basierend auf dem den Strom durch das Leuchtmittel wiedergebenden Parameter, die erste Diagonale des Gleichrichters (AG') synchron mit einem ersten Wechselrichterschalter (Q₁) der Halbbrücken-Schaltereinheit (S) und unter Verwendung des Steuersignals dieses ersten Wechselrichterschalter^{s} (Q₁) aktiviert und deaktiviert und wobei die Steuereinheit (SE") die zweite Diagonale des Gleichrichters (AG") synchron mit einem zweiten Wechselrichterschalter (Q₂) der Halbbrücken-Schaltereinheit (S) und unter Verwendung des Steuersignals dieses zweiten Wechselrichterschalters (Q₂) aktiviert und deaktiviert, und wobei jeweils nur die erste oder die zweite Diagonale aktiv ist, und
• eine Integrationsschaltung (I), der der Strom durch die jeweils aktivierte Diagonale des Gleichrichters (AG') zugeführt wird und die diesen Strom inteizriert.

## Claims

1. Driver circuit for operating an illuminant, preferably at least one LED, comprising:
• an electrically isolated LLC converter which is clocked on the primary side by a control unit (SE") of the driver circuit by means of a controlled half-bridge switch unit (S) with downstream series resonant circuit (C1, L1) and feeds a rectifier (D1, D2) of the driver circuit on a secondary side of the converter from which the illuminant can be supplied,
• wherein the converter has a first transformer with two windings (L2-2, L2-3) with central tapping on the secondary side,
• wherein the rectifier has two diodes (D1, D2) which are each connected in series to one of the two windings of the first transformer,
• a detection circuit (E") of the driver circuit for indirectly detecting the current on the secondary side of the converter,
• wherein on the secondary side of the first transformer of the converter in each case one primary winding (L3_1, L3_2) of a second transformer (L3_1, L3_3) of the driver circuit is arranged in series with in each case one of the two diodes (D1, D2),
• wherein the detection circuit (E") has a detection rectifier (AG) arranged on the primary side of the converter, and a secondary winding (L3_3) of the second transformer (L3_1, L3_3) is part of a first and a second diagonal of the detection rectifier (AG'),
• wherein the first and second diagonals each have two rectifier switches (Q3, Q4, Q5, Q6),
• wherein a parameter representing the current through the illuminant is fed back to the control unit (SE") from an output of the detection circuit (E"), and the output is connected directly or indirectly to a measurement input of the control unit (SE"),
• wherein on the basis of the parameter representing the current through the illuminant, the control unit (SE") activates and deactivates the first diagonal of the rectifier (AG') synchronously with a first inverter switch (Q1) of the half-bridge switch unit (S) by using the control signal of said first inverter switch (Q1) and wherein the control unit (SE") activates and deactivates the second diagonal of the rectifier (AG") synchronously with a second inverter switch (Q2) of the half-bridge switch unit (S) by using the control signal of said second inverter switch (Q2), and wherein only the first or the second diagonal is active in each case, and
• an integration circuit (I) to which the current is supplied through the respectively activated diagonal of the rectifier (AG') and which integrates this current.

## Revendications

1. Circuit d'attaque destiné au fonctionnement d'un agent lumineux, de préférence au moins une DEL, présentant :
• un convertisseur LLC à isolement électrique, cadencé côté primaire par une unité de commande (SE") du circuit d'attaque au moyen d'une unité de commutation en demi-pont commandée (S) comprenant le circuit résonant série suivant (C1, L1), qui alimente un redresseur (D1, D2) du circuit d'attaque sur un côté secondaire du convertisseur, à partir duquel l'agent lumineux peut être alimenté,
• le convertisseur présentant un premier transformateur avec deux enroulements (L2-2, L2-3) avec une prise médiane sur le côté secondaire,
• le redresseur présentant deux diodes (D1, D2), qui sont respectivement connectées aux deux enroulements du premier transformateur en série,
• un circuit de détection (E") du circuit d'attaque pour la détection indirecte du courant sur le côté secondaire du convertisseur,
• sur le côté secondaire du premier transformateur du convertisseur, un enroulement primaire (L3_1, L3_2) d'un second transformateur (L3_1, L3_3) du circuit d'attaque étant disposé en série avec l'une respective des deux diodes (D1, D2),
• le circuit de détection (E") présentant un redresseur de détection (AG) disposé sur le côté primaire du convertisseur et un enroulement secondaire (L3_3) du second transformateur (L3_1, L3_3) formant une partie d'une première et d'une seconde diagonale du redresseur de détection (AG'),
• la première et la seconde diagonale présentant respectivement deux commutateurs de redresseur (Q3, Q4, Q5, Q6),
• un paramètre reproduisant le courant traversant l'agent lumineux étant renvoyé à l'unité de commande (SE") par une sortie du circuit de détection (E") et la sortie étant connectée directement ou indirectement à une entrée de mesure de l'unité de commande (SE"),
• l'unité de commande (SE"), sur la base du paramètre reproduisant le courant traversant l'agent lumineux, activant et désactivant la première diagonale du redresseur (AG') de manière synchrone avec un premier commutateur d'onduleur (Q1) de l'unité de commutation en demi-pont (S) et en utilisant le signal de commande de ce premier commutateur d'onduleur (Q1) et l'unité de commande (SE") activant et désactivant la seconde diagonale du redresseur (AG") de manière synchrone avec un second commutateur d'onduleur (Q2) de l'unité de commutation en demi-pont (S) et en utilisant le signal de commande de ce second commutateur d'onduleur (Q2) et respectivement seule la première ou la seconde diagonale étant active et
• un circuit d'intégration (I), auquel le courant est amené par le biais de la diagonale respectivement activée du redresseur (AG') et qui intègre ce courant.
